# EUROPEAN PATENT APPLICATION

(11) **EP 1 892 275 A2**
(43) Date of publication of application: **27.02.2008**
(21) Application number: 07016007.2
(22) Date of filing: 14.08.2007
(51) Int. Cl.: C09J 7/02, B23K 26/42

(54) **Adhesive sheet for laser processing**

(30) Priority: 22.08.2006 JP 2006224936
(71) Applicant: Nitto Denko Corporation, Ibaraki-shi, Osaka 567-8680 (JP)
(72) Inventor: Sasaki, Takatoshi, Ibaraki-shi Osaka 567-8680 (JP); Takahashi, Tomokazu, Ibaraki-shi Osaka 567-8680 (JP); Asai, Fumiteru, Ibaraki-shi Osaka 567-8680 (JP); Yamamoto, Akiyoshi, Ibaraki-shi Osaka 567-8680 (JP); Shintani, Toshio, Ibaraki-shi Osaka 567-8680 (JP)
(74) Representative: Hager, Thomas Johannes

(57) **Abstract**

An adhesive sheet for laser processing, comprises a base film and an adhesive layer laminated on the surface of the base film, wherein the base film has a melting protection layer on the back side thereof. According to the adhesive sheet for laser processing of the present invention, the melting of the base film caused by the local concentration of laser beam energy at the places irradiated with the laser beam can be effectively prevented. Accordingly, the back side of the base film can be prevented from locally adhering to the processing table in the dicing apparatus, and subsequent steps, namely, drawing the base film to separate the workpiece from the adhesive layer, and individually recovering these, can be carried out easily and efficiently.

## Description

### BACKGROUND OF THE INVENTION

### 1. Field of the Invention

The present invention relates to an adhesive sheet for laser processing, and more particularly relates to an adhesive sheet of laser processing which is used for dicing a workpiece, such as a semiconductor wafer, by laser beam.

### 2. Background Information

Electrical and electronic parts have been decreasing in size and increasing in fineness as devices have become smaller, etc., recently. Accordingly, there is a need for greater fineness and precision in the cutting of various materials. In particular, in the semiconductor field, in which there is a great need for smaller size and higher density, attention in recent years has been focusing on methods for cutting semiconductor wafers with a laser beam, which causes no heat damage and allows high-precision processing.

This technique is a method for fixing a workpiece, obtained by subjecting a substrate to various circuit formation and surface processing steps, to a dicing sheet, and dicing the workpiece with a laser beam to create small chips (see JP- 2004-79746A, for example). Also, there has been proposed a dicing sheet comprising a base including a base film, and an adhesive layer formed on the surface of this base, with which the adhesive layer is cut by the laser beam without cutting the base film (see JP 2002-343747A, for example).

However, when a laser beam is used to dice a workpiece, it is extremely difficult to control the beam so that just the adhesive layer is cut and not the base film. Even if just the adhesive layer could be cut, there would still be that the back side of the base film adhered tightly and locally to the chuck table of the dicing apparatus at the places irradiated with the laser beam. Consequently, this complicates subsequent steps, namely, steps such as drawing the base film to separate the workpiece and recovering the cut pieces individually.

The present invention was conceived in light of this situation, and it is an object thereof to provide an adhesive sheet for laser processing, with which, when a semiconductor wafer or other such workpiece is cut with a laser beam, the cutting of the base film itself is kept to a minimum, the local adhesion of the base film to the processing table is prevented, and subsequent steps can be carried out easily and efficiently.

### SUMMARY OF THE INVENTION

As a result of diligent research into the phenomenon whereby a base film and a processing table locally adhere firmly together where irradiated with a laser beam during dicing with a laser dicing apparatus, the inventors assumed that the energy of the laser beam reaches the back side of the base film and concentrates locally, which generates heat, and this concentration of laser beam energy and the resulting generation of heat contribute to the melting of the base film material and so forth, and found specific conditions, or a combination thereof, under which this problems can be kept to a minimum, finally arrived at the present invention.

The present invention provides an adhesive sheet for laser processing, comprising a base film and an adhesive layer laminated on the surface of the base film,
wherein the base film has a melting protection layer on the back side thereof.

With the adhesive sheet for laser processing of the present invention, the melting of the base film caused by the local concentration of laser beam energy at the places irradiated with the laser beam can be effectively prevented. Accordingly, the back side of the base film can be prevented from locally adhering to the processing table in the dicing apparatus. Therefore, subsequent steps, namely, drawing the base film to separate the workpiece from the adhesive layer, and individually recovering these, can be carried out easily and efficiently.

In particular, if the melting protection layer is composed of a material having a melting point of at least 200°C, the melting of the base film can be prevented more effectively on the base film back side, and the phenomenon of local adhesion to the processing table can be suppressed.
Also, if the melting protection layer has a layer made of a material selected from the group consisting of an inorganic compound, a metal, an organic compound and a combination thereof, the melting protection layer with a high melting point can be easily formed.

Furthermore, if the base film has the transmissivity of at least 50%, deterioration of the base film itself by the laser beam can be prevented.
Also, if the base film comprises at least one layer containing a polyolefin resin, the optical transmissivity and/or the optical absorption coefficient with respect to the laser beam being used can be set relatively high, making the base film itself more resistant to processing, that is, to being cut.

In particular, if the polyolefin resin is at least one resin selected from the group consisting of polyethylene, polypropylene, polyethylene copolymer, propylene copolymer, ethylene-propylene copolymer, if the base film preferably includes at least two layers with different fracture elongation, and the layer with the greater fracture elongation is disposed adjacent to the melting protection layer, or if the layer with the greater fracture elongation has a fracture elongation of at least 100%, the optical transmissivity and/or the optical absorption coefficient with respect to the laser beam being used can be set relatively high, making the base film itself more resistant to being cut.

The adhesive sheet for laser processing of the present invention can be utilized in a wide range of any kinds of applications such that it is applied to semiconductor wafers (such as silicon wafer, germanium wafer, gallium arsenide wafer), circuit boards, ceramic substrates, metal substrates, substrates for light-emitting diode (e.g. semiconductor laser) and photoreceptor, substrates for MEMS (micro electro mechanical system), semiconductor packages and the like.

### BRIEF DESCRIPTION OF THE DRAWINGS

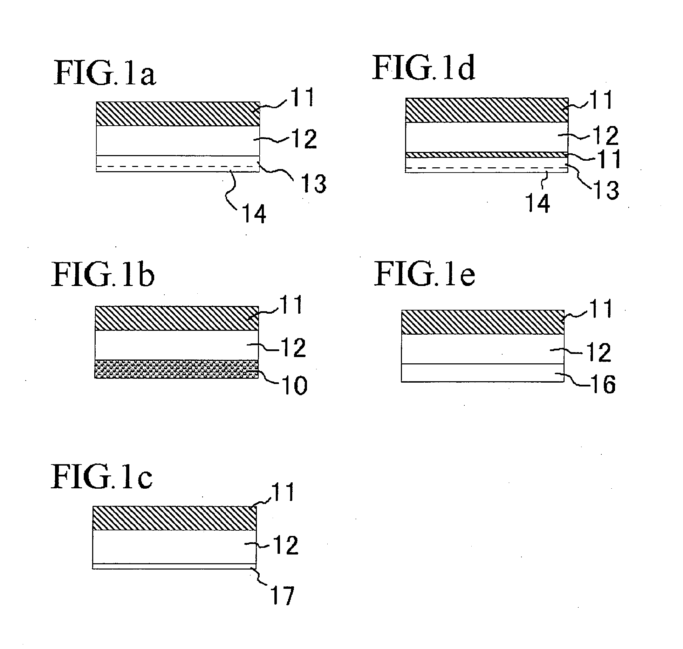

FIGs. 1a to 1e are simplified cross sectional views of the adhesive sheet of laser processing of the present invention.

### DETAILED DESCRIPTION OF THE PREFERRED EMBODIMENTS

The adhesive sheet for laser processing of the present invention mainly comprises a base film, an adhesive layer disposed on the front side of this base film and a melting protection layer laminated/formed on a back side of this base film.
The melting protection layer formed on the back side of the base film is a layer that either is not melted at all or is resistant to being melted by irradiation with a laser beam, and is a layer for protecting the back side of the base film so that the base film will not adhere to the processing table or the like as a result of melting, etc.

The melting protection layer can be formed from a material having a melting point of at least 200°C, for example. It is preferably for the material having a melting point of at least 220°C, at least 230°C, or at least 250°C. This will prevent adhesion to the processing table, etc., due to melting or the like of the base film at the places where laser beam energy concentrates.
Also, even if the melting point of the melting protection layer is not necessarily 200°C or more, if an inorganic compound, metal, or the like (discussed below) is contained in those portions, then the melting protection layer may still be able to prevent melting or adhesion to the processing table, etc., due to the energy of the laser beam.

The melting protection layer can have a single-layer structure or a laminated structure of two or more layers, in which an inorganic compound, a metal, an organic compound, or the like is contained, or a combination of these is contained.
More specifically, examples of inorganic compounds include inorganic microparticles of silica (fumed silica, silicic anhydride, precipitated silica, molten silica, crystalline silica, ultrafine powdered amorphous silica or the like), metallic oxides (aluminum oxide, titanium dioxide, tin II oxide, tin IV oxide, zinc oxide, calcium oxide, magnesium oxide or the like), metallic nitride (silica nitride, aluminum nitride or the like), metallic carbides (SiC or the like), metallic carbonates (potassium carbonate, sodium carbonate, calcium carbonate, magnesium carbonate or the like), metallic hydroxides (aluminum hydroxide, magnesium hydroxide or the like), barium titanate, calcium phosphate, calcium silicate, gypsum, zeolite, talc, clay, barium sulfate, mica, diatomic earth, metal powders (gold, silver, palladium, platinum, nickel or the like) and the like. These can be used in a variety of shapes, such as spheres, needles, or flakes, and can have a size ranging from about 1 µm to several hundred microns.

The melting protection layer may be formed, for example, by dispersing the inorganic compound as the above-mentioned particles in a suitable solvent, using this solution to coat the back side of the base film, and drying the coating, or one of the organic compounds discussed below (and preferably the same material as the base film, or a polymer with a melting point of at least 200°C) may be used as a binder, a suitable solvent is used, the particles are dispersed or dissolved in this, and thus obtained solution is used to coat the back side of the base film. Also, as shown in FIG. 1c, the melting protection layer may be formed, for example, an inorganic compound may be dispersed during the extrusion molding of a polymer (and preferably the same material as the base film, or a polymer with a melting point of at least 200°C) to form a layer 10, this layer 10 is applied to a base film 12 on which an adhesive layer 11 has been formed by hot lamination or with another adhesive layer, for example. In this case, the inorganic compound can be contained in the dispersion layer 10 in an amount of about 5 to 80 wt%, 10 to 60 wt%, 10 to 40 wt%, for example.

The metal includes aluminum, gold, cupper or the like, refractory metal (such as nickel, titanium, tungsten tantalum) or the like, and oxides and nitride thereof.
The melting protection layer can also be a film of metal formed by vapor deposition, sputtering, or another such method. The metal is preferably formed directly over the base film, but as shown in FIG. 1a, for example, a metal layer 14 may be formed separately from a base film 12 on a resin film 13 formed from the same material as the base film or a polymer as discussed below (preferably the same material as the base film, a polymer with a melting point of at least 200°C), and the resin film 13 on which this metal layer 14 is formed may be applied to the base film 12 by hot lamination, for example. Also, as shown in FIG. 1b, an adhesive layer 11 may be used, for example, to apply the resin film 13 on which the metal layer 14 is formed to the base film 12. In this case, the resin film 13 and the adhesive layer 11 may constitute part of the base film, as opposed to being a melting protection layer per se.

The organic compound includes polyolefin such as polyethylene, polypropylene; polyester such as PET; thermoplastic resin such as nylon; thermoplastic polyimide; fluorine-containing polyethylene such as PTFE, ETFE, polycarbonate; polyester and the like. Among these, the organic compounds having a melting point of at least 200°C are preferable.

As shown in FIG. 1d, the organic compound may be formed as a film, and this organic film 16 is applied by hot lamination or the like to the base film 12 on which the adhesive layer 11 has been formed, thereby constituting a melting protection layer, or as shown in FIG. 1e, the above-mentioned organic compound may be dissolved or dispersed in a suitable solvent and used to coat the base film 12 by spraying or various other coating methods, and this coating dried, thereby forming a melting protection layer 17 in the form of a film.

There are no particular restrictions on the thickness of the melting protection layer, but an example is a range of about 0.001 to 10 µm. Forming the melting protection layer within this thickness range effectively prevents adhesion of the base film to the processing table by melting or the like.
The base film can be selected from among any known film with self-supporting properties. The base film is preferably in the form of a sheet with a uniform thickness, but may also be in the form of a mesh or the like. Also, the base film may be a single layer, or may have a multilayer structure of two or more layers.

Examples of the material for the base film include polymer films such as an acrylic resin, a polyurethane resin, a polynorbornene resin, a polyalkyleneglycol resin, a polyolefin resin (e.g. polystyrene and polyethylene resin), a polyimide resin, a polyester resin, a epoxy resin, a polyamide resin, a polycarbonate resin, a silicon resin, a fluorocarbon polymer; metallic sheets such as cupper, aluminum, stainless steel; non-woven clothes made of polymeric fibers such as PP, PVC, PE, PU, PS, PO, PET, synthetic fibers such as rayon, cellulose acetate, natural fibers such as cotton, silk, wool and inorganic fibers such as a glass fiber, a carbon fiber; sheets which are made of materials described above and are provided physical or optical functions by drawing process, impregnating process or the like thereto; sheets containing rubber component, for example, dienes such as styrene-butadiene copolymer, butadiene, non-dienes such as isobutylene-isoprene, chlorinated polyethylene, urethanes, thermoplastics such as thermoplastic elastomer; or combination of at least two thereof.

Among these, polyolefin resins, for example, polyethylene (e.g., low-density polyethylene, liner low-density polyethylene, high-density polyethylene, etc.), polypropylene (e.g., drawn polypropylene, non-drawn polypropylene, etc.), ethylene-polypropylene copolymer, ethylene copolymer, propylene copolymer or the like are preferable. In case that the base film is multilayer structure, it is preferable that at least one layer includes polyolefin resins.

When one or more, preferably all of characteristics of optical transmissivity, lamination condition, fracture elongation, absorption coefficient, melting point, thickness, fracture strength, specific heat, etching rate, Tg, thermal deflection point, specific gravity, also thermal deflection point, pyrolysis temperature, coefficient of linear expansion and so forth are taken into account (described below), it is particularly favorable for the base film material to be selected from among materials that will make the workpiece resistant to being cut with a laser beam.

The base film preferably has a thickness of at least 50 µm, more preferably at least 100µm, at least 150µm, about 50 to 100µm. This facilitates work and operation in the various steps, such as application to a semiconductor wafer, cutting of the semiconductor wafer, and separation from semiconductor chips.

Within the applied range of film thickness, the transmissivity of the base film with respect to the laser beam, and particularly its transmissivity of laser light with a wavelength of from close to 355 nm to close to 600 nm, is at least about 50%, at least about 55%, at least about 60%, at least about 65%. The optical transmissivity can be measured using a spectrophotometer for the ultraviolet and visible region. As a result, deterioration of the base film itself by the laser beam can be prevented. The optical transmissivity of the base film here means the value in a state in which no melting protection layer is present, but when a melting protection layer formed as a film is applied to the base film, or when it is applied with an adhesive layer, there is no need to hold to the strict meaning, and this may instead be the value in a state in which the melting protection layer formed as a film has not been applied. This is because the optical transmissivity usually does not vary greatly when the material, thickness, and so forth of this film or adhesive layer are taken into account.

Also, the base film preferably has a multilayer structure of two or more layers of different materials. The phrase "different materials" here encompasses not only materials of different compositions, but also materials whose compositions are the same, but whose characteristics differ because of differences in molecular structure, molecular weight, etc. For instance, it is favorable to laminate materials with one or more different characteristics, such as the above-mentioned absorption coefficient, melting point, fracture strength, fracture elongation, optical transmissivity, specific heat, etching rate, thermal conductivity, Tg, thermal deflection point, pyrolysis temperature, coefficient of linear expansion, or specific gravity.

Of laminate structures with two or more layers, it is especially favorable for at least one layer to be a resin containing no benzene rings or containing a linear saturated hydrocarbon resin, such as a polyolefin resin. Polyolefins include at least one of polyethylene, polypropylene, polyethylene copolymer, propylene copolymer, ethylene-propylene copolymer, polybutadiene, polyvinyl alcohol, polymethyl pentene, ethylene- vinyl acetate copolymer, polyvinyl acetate. Among these, ethylene or propylene (co)polymer is preferable, and at least one of polyethylene, polypropylene, ethylene copolymer, propylene copolymer, ethylene-propylene copolymer is more preferable. Selecting one of these materials strikes a good balance between stretchability and adequate strength with respect to laser processing.

When the base film has a laminate structure, it preferably includes both a polyethylene resin layer and a polypropylene resin layer. It is particularly preferable to use a two- or three-layer structure including these layers. In this case, the polypropylene resin layer is preferably disposed farther away from the adhesive layer. For example, in the case of a two-layer structure, it is preferable if the polypropylene resin layer is disposed on the back side of the base film, and the polyethylene resin layer on the adhesive layer side, and in the case of a three-layer structure, it is preferable if the polypropylene resin layer is disposed on the back side of the base film or one layer away toward the adhesive layer, and the polyethylene resin layer on the adhesive layer side. With this construction, even if part of the base film should be damaged during laser processing, suitable stretchability will still be ensured in the base film by the polypropylene resin layer, which is a relatively soft resin and is present on the outermost back side.

The base film preferably includes two or more layers with different fracture elongation. Fracture elongation can be measured, for example, as set forth in JIS K 7127, using a universal tensile tester at a pulling rate of 200 mm/minute. There are no particular restrictions on the difference in the fracture elongation, but at least about 100% is an example, and at least about 300% is preferable. In this case, it is preferable if the layer with the greater fracture elongation is disposed farther away from the adhesive layer. In other words, the layer with better stretchability is preferably disposed on the back side of the base film, that is, on the side that is less likely to be cut by the laser beam.

It is particularly favorable for the base film to have a fracture elongation of at least 100%. If the base film has a laminated structure, not all of the layers necessarily have to have a fracture elongation of at least 100%, but at least the layer with the better stretchability is preferably disposed on the outermost back side of the base film. A base film whose fracture elongation is at least 100% and whose fracture strength is within the described below range is particularly preferable because after laser dicing has been performed, the dicing sheet can be stretched to easily separate the chips formed by cutting the workpiece.

Also, the base film preferably includes two or more layers with different fracture strength. The fracture strength here can be measured as set forth in JIS K 7127, using a universal tensile tester at a pulling rate of 200 mm/minute. There are no particular restrictions on the difference in the fracture strength, but about 20 MPa or more is suitable, for example, and about 50 MPa or more is preferable. In this case, it is preferable if the layer with the greater fracture strength is disposed farther away from the adhesive layer. In other words, the layer that is stronger and less likely to be cut by the laser beam is preferably disposed on the back side of the base film.

The base film preferably includes a layer whose melting point is at least 90°C, because this will effectively prevent the base film from being melted by irradiation with the laser beam. Also, melting point of at least 95°C, at least 100°C, or at least 110°C is more preferable. If the base film has a single-layer structure, the melting point of that layer itself must be at least 90°C, but if the base film has a laminated structure, not all of the layers necessarily have to have a melting point of at least 90°C, and at least one layer preferably has a melting point of at least 90°C. In this case, that one layer is preferably disposed on the side that will be the back side during laser processing (such as the side in contact with the chuck table).

The base film also preferably has a high specific heat. For instance, the specific heat is preferably at least about 0.5 J/g·K, at least about 0.7 J/g·K, at least about 0.8 J/g·K, at least about 1.0 J/g·K, at least about 1.1 J/g·K, or at least about 1.2 J/g·K,. A relatively high specific heat makes it less likely that the base film itself will be heated by the heat generated by the laser beam, and allows part of that heat to escape to outside the base film. As a result, the base film is more resistant to processing, the cutting of the base film is kept to a minimum, and the back side can be prevented from adhering locally to the processing table. The specific heat can be measured as set forth in JIS K 7123. More specifically, it can be found by using a differential scanning calorimeter (DSC) to measure the amount of heat required to raise the temperature of a test piece at 10°C/mm².

Furthermore, the base film preferably has a low etching rate. For instance, the etching rate is preferably from about 0.3 to 1.5 µm/pulse, from about 0.3 to 1.2 µm/pulse or from about 0.3 to 1.1 µm/pulse at a laser beam intensity of about 1 to 5 J/cm². In particular, the etching rate is preferably at most about 0.9 µm/pulse, at most about 0.8 µm/pulse or at most about 0.7 µm/pulse at a laser beam intensity of about 1 to 2 J/cm².
A lower etching rate prevents the base film itself from being cut.

It is preferable for the base film to have a glass transition point (Tg) of at most about 50°C, at most about 30°C, at most about 20°C, at most about 0°C, or a thermal deflection point of at most about 200°C, at most about 190°C, at most about 180°C, at most about 170°C, or a specific heat of at most about 1.4 g/cm³, at most about 1.3 g/cm³, at most about 1.2 g/cm³, at most about 1.0 g/cm³. Having the above characteristics is advantageous in that it allows the cutting of the base film to be kept to a minimum and prevents the back side form locally adhering to the processing table. The Tg and the thermal deflection temperature can be measured, for example, by a standard method for measuring the transition temperature of a plastic as set forth in JIS K 7121 (more specifically, they can be measured by using differential thermal analysis (DTA), differential scanning calorimetry (DSC) or the like). Specific gravity can be measured by a commonly known method for measuring the density (specific gravity) of a plastic as set forth in JIS K 7112 (more specifically, underwater replacement, pycnometry, sink-and-float analysis, a density gradient method, etc.).

In order to improve the supportability, adhesion with adjacent materials of the table and so forth in the processing apparatus, and so on of the surface of the base film, this surface may be subjected, for example, to a chromate treatment, ozone exposure, flame exposure, high-voltage electrical shock exposure, ionizing radiation treatment, or other such chemical or physical treatment, or to coating with a primer (such as the adhesive discussed below), or another such known surface treatment.

There are no particular restrictions on the adhesive layer formed on the adhesive sheet for laser processing of the present invention, but it can be formed, for example, by using an adhesive composition that is known in this field and that contains a thermosetting resin, thermoplastic resin, energy radiation-curing resin (that is cured by radiation with UV rays, an electron beam, or the like) or the like. The use of an energy radiation-curing resin is particularly preferable because it improves the release characteristics of the workpiece. This is because irradiation lowers the adhesive strength to form a three-dimensional reticulated structure within the adhesive, and facilitates release characteristics after use. There are no particular restrictions on the adhesive, but it can be used for the adhesive described in, for example, JP-2002-203816-A, JP2003-142433-A, JP2005-19607-A, JP2005-279698-A, JP2006-35277-A, JP2006-111659-A and the like.

More specifically, examples include natural rubber, various kinds of synthetic rubber, and other such rubbers, and compounds containing an acrylic polymer such as an alkyl poly(meth)acrylate manufactured from acrylonitrile and an alkyl acrylate or alkyl polymethacrylate having linear or branched alkyl groups with about 1 to 20 carbons.

A multifunctional monomer can be added into the adhesive as a crosslinking agent. Examples of the crosslinking agent include hexandiol di(meth)acrylate, (poly)ethylene glycol di(meth)acrylate, urethane acrylate and the like. The crosslinking agent can be used alone or as a mixture of more than two compounds.

To obtain an energy radiation-curing adhesive, a monomer or oligomer that readily reacts under optical irradiation, which is known as a photopolymerizable compound, is preferably combined. Examples of these include urethane, methacrylate, trimethyl propane trimethacrylate, tetramethylol methane tetramethacrylate, 4-butylene glycol dimethacrylate and the like.

Moreover, in this case, a photopolymerization initiator may be also included. Examples of the initiator include acetophenone compounds such as 4-(4-hydroxyethoxy) phenyl(2-hydroxy-2-propyl)ketone, benzoine ether compounds such as benzoine ethyl ether, ketal compounds, aromatic sulfonyl chloride compounds, light-active oxime compounds and benzophenone compounds. These compounds can be used alone or as mixtures thereof.

To obtain a thermosensitive adhesive, what is known as a thermofoaming component (decomposition type or microcapsule type) may be used. See European Patent 0523505, for example.
The adhesive may further comprise any appropriate additive such as tackifiers, fillers, pigments, anti-aging agents or stabilizers, softening agents incorporated therein, if necessary.
There are no particular restrictions on the thickness of the adhesive layer, but about 300 µm or less, or a range of about 3µm to 200 µm, for example, is preferable with taking into account obtaining sufficient strength and not leaving any undesirable adhesive residue behind after the adhesive sheet has been removed from the semiconductor wafer or the like.

The adhesive sheet for laser processing of the present invention can be formed by any known method in this field. For example, as discussed above, an adhesive component is prepared, this is used to coat the base film, and the coating is dried. Any of various methods can be employed to apply the adhesive component coating methods such as bar coator coating, air knife coating, gravure coating, gravure reverse coating, reverse roll coating, rip coating, die coating, dip coating, offset printing, flexographic printing, screen printing and other industrially applied coating methods may be used.. Another example of a method that can be employed is to separately form an adhesive layer on a stripping liner, and then affix this to the base film.

The adhesive sheet for laser processing of the present invention is preferably used for processing utilized laser light. The laser light includes one with an oscillation wavelength less than 400 nm, such as a third or fourth harmonic of a YAG laser with an oscillation wavelength of 355 nm, XeCl excimer laser with an oscillation wavelength of 308 nm, or KrF excimer laser with an oscillation wavelength of 248 nm, as well as one with an oscillation wavelength greater than 400 nm, such as a titanium sapphire laser with a wavelength from 750 nm to 800 nm, with pulse width of 1 e⁻⁹ second or less.

The adhesive sheet for laser processing of the present invention can be applied to semiconductor wafers (such as silicon wafer, germanium wafer, gallium arsenide wafer), circuit boards, ceramic substrates, metal substrates, substrates for light-emitting diode (e.g. semiconductor laser) and photoreceptor, substrates for MEMS (micro electro mechanical system), semiconductor packages and the like. That is, the adhesive sheet is, for example, prior to dicing with a laser beam, used to applied on the processing table in the dicing apparatus side of the semiconductor wafer, and during its cutting and in a subsequent step, to support and fix individual chips that have been separated.

In this usage of the laser processing sheet of the present invention, the adhesive layer, or the adhesive layer and part of the base film, is or are cut along with the semiconductor wafer or the like, but the base film on the processing table side is not cut, which prevents the individually separated chips, etc., from scattering or falling. Also, since the base film is not melted at the places irradiated with the laser beam, the back side of the base film can be prevented from locally adhering to the processing table of the dicing apparatus.

The adhesive sheet for laser processing of the present invention will now be described in specific terms, but the present invention is not limited to or by the following Examples.

### Example 1

### (Acrylic Adhesive)

100 weight parts acrylic polymer having number-average molecular weight of 500000 and copolymerized by butyl acrylate/ ethyl acrylate/ 2-hydroxy ethyl acrylate/ acrylic acid at weight ratio of 60/40/4/1, 3 weight parts isocyanate crosslink agent (Coronate HL, made by Nippon Polyurethane Industry Co., Ltd.), 2 weight parts epoxy crosslinking agent (Tetrad C, made by Mitsubishi Gas Chemical) was added to 500 weight parts toluene and uniformly dissolved and mixed to prepare an acrylic adhesive solution. This solution was used to coat a PET separator (a PET film coated with a silicone parting agent), and this coating was dried for 3 minutes at 120°C to obtain an adhesive layer A with a thickness of 10 µm.

### (Base Film + Melting Protection Layer)

An aluminum vapor deposited polypropylene film (film thickness: 25 µm, VM-CPP 2203, made by Toray Film Products; thickness of aluminum layer: approximately 0.1µm) was applied by hot lamination to the back side of a polypropylene composite film B (m.p.: 130°C or less) of polypropylene (20µm) / polyethylene (60µm) / polypropylene (20 µm) film to obtain a base film equipped with a melting protection layer. The lamination temperature was 80°C. Note: aluminum melting point: 660°C; fracture elongation of polypropylene: 600%; fracture elongation of polyethylene: 500%; optical transmissivity of entire base film excluding the aluminum layer: approximately 85% (400 to 600 nm), approximately 70% (355 nm).

### (Adhesive Sheet for Laser Processing)

As shown in FIG. 1a, an adhesive layer A11 was affixed to the opposite side of a base film 12 to which had been affixed a resin film 13 including a melting protection layer comprising the above-mentioned metal layer (vapor deposited aluminum layer) 14, which gave an adhesive sheet for laser processing equipped with a melting protection layer.

### (Test Piece)

The adhesive sheet for laser processing equipped with a melting protection layer was press-bonded to a silicon mirror wafer (made by Shin-Etsu Semiconductor, CZN<100>2.5 to 3.5 (4 inch)) using a 2 kg rubber roller as set forth in JIS K 6253 and under conditions of moving the roller one back and forth over the wafer.

### (Dicing)

The silicon mirror wafer to which the adhesive sheet for laser processing had been affixed was disposed, with the adhesive sheet side down, on a chuck table having a quartz glass chucking plate. A third harmonic (355 nm) of a YAG laser with a wavelength of 355 nm, an average output of 5 W, and a repeated frequency of 30 kHz was focused with an fθ lens to a diameter of 25 µm on the surface of a polyimide film, and the laser beam was scanned with a galvano scanner at a rate of 20 mm/second to cut the wafer.
After cutting the wafer, no fusion was seen between the adhesive sheet and the chuck table.

### Example 2

As shown in FIG. 1b, an adhesive sheet for laser processing equipped with a melting protection layer was produced by affixing the melting protection layer using an adhesive layer A11 (5 µm thick) instead of hot lamination in the affixing of the aluminum vapor deposited polypropylene film (VM-CPP 2203, made by Toray Film Products) (the resin film 13 equipped with the metal layer 14) as the melting protection layer to the back side of a polypropylene/polyethylene composite film B (the base film 12).
The adhesive sheet for laser processing thus obtained was cut in the same manner as in Example 1, and no fusion was seen between the adhesive sheet and the chuck table.

### Example 3

### (Silica Dispersed EVA Sheet)

100 g of Everflex EV450 (ethylene-vinyl acetate copolymer resin, melting point of 84°C, made by Mitsui-DuPont Chemical) was mixed into 400 g of toluene. The mixture was then stirred for 1 hour at 50°C to obtain a polymer solution. 30 g of Silica Filler PLV-4 (made by Tatsumori) with an average particle size of 4 µm was added and stirred for 30 minutes until uniform, which gave a silica filler-dispersed solution. Note: silica melting point: 154°C.
The silica filler-dispersed solution thus obtained was used to coat a PET separator (PET film coated with a silicone parting agent), and this coating was dried for 3 minutes at 120°C to obtain a silica filler-dispersed resin layer with a thickness of 20 µm.

As shown in FIG. 1c, this silica filler-dispersed resin layer 10 was affixed to a polypropylene/polyethylene composite film B (the base film 12) by 80°C hot lamination, and then the adhesive layer A1 was affixed to the opposite side of a silica filler dispersion resin layer 10, which gave an adhesive sheet for laser processing equipped with a melting protection layer.
The adhesive sheet for laser processing thus obtained was cut in the same manner as in Example 1, and no fusion was seen between the adhesive sheet and the chuck table.
It is believed that since this silica filler-dispersed resin layer 10 contained approximately 23 wt% silica filler in the polymer, the resin was prevented from melting by the silica filler, and this prevented fusion to the chuck table.

### Example 4

As shown in FIG. 1d, a 30 µm heat-resistant film (Floun ETFE, made by Asahi Glass; melting point of 260°C) was affixed as an organic film 16 (formed from an organic compound) by hot lamination at 80°C to the back side of a polypropylene/ polyethylene composite film B (the base film 12). An adhesive layer A 11 was affixed to the opposite side of the base film 12 thus obtained, to produce an adhesive sheet for laser processing equipped with a melting protection layer.
The adhesive sheet for laser processing thus obtained was cut in the same manner as in Example 1, and no fusion was seen between the adhesive sheet and the chuck table.

### Example 5

As shown in FIG. 1e, the back side of a polypropylene/polyethylene composite film B (the base film 12) was sprayed with RTV Silicone Spray FC112 (made by Fine Tech Japan, temperature of heat resistance: 200 °C), and this coating was dried for 30 minutes at 23°C and a humidity of 50% to form a melting protection layer 17. The average thickness of this melting protection layer after drying was 20 µm. An adhesive layer A11 was affixed to the opposite side of the melting protection layer 17, which gave an adhesive sheet for laser processing equipped with a melting protection layer.
The adhesive sheet for laser processing thus obtained was cut in the same manner as in Example 1, and no fusion was seen between the adhesive sheet and the chuck table.

### Comparative Example 1

An experiment was conducted in the same manner as in Example 1, except that no melting protection layer was provided to the back side as in Example 1. After cutting, part of the adhesive sheet was confirmed to have fused to the chuck table.
This application claims priority to Japanese Patent Application No. 2006-224936. The entire disclosure of Japanese Patent Application No. 2006-224936 is hereby incorporated herein by reference.
While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims and their equivalents. Thus, the scope of the invention is not limited to the disclosed embodiments.

## Claims

1. An adhesive sheet for laser processing, comprising a base film and an adhesive layer laminated on the surface of the base film,
wherein the base film has a melting protection layer on the back side thereof.

2. The adhesive sheet according to Claim 1, wherein the melting protection layer is composed of a material having a melting point of at least 200°C.

3. The adhesive sheet according to Claim 1, wherein the melting protection layer have a layer made of a material selected from the group consisting of an inorganic compound, a metal, an organic compound and a combination thereof.

4. The adhesive sheet according to Claim 1, wherein the base film has the transmissivity of at least 50%.

5. The adhesive sheet according to Claim 1, wherein the base film comprises at least one layer containing a polyolefin resin.

6. The adhesive sheet according to Claim 1, wherein the polyolefin resin is at least one resin selected from the group consisting of polyethylene, polypropylene, polyethylene copolymer, propylene copolymer, ethylene-propylene copolymer.

7. The adhesive sheet according to Claim 1, wherein the base film includes at least two layers with different fracture elongation, and the layer with the greater fracture elongation is disposed adjacent to the melting protection layer.

8. The adhesive sheet according to Claim 1, wherein the layer with the greater fracture elongation has a fracture elongation of at least 100%.
